Europäisches Patentamt

European Patent Office

Office européen des brevets

(19)

(11) Publication number: **0 309 773 B1**

# EUROPEAN PATENT SPECIFICATION

(45) Date of publication of patent specification: 04.12.91    (51) Int. Cl.⁵: **C23F 4/00**, H01L 21/31

(21) Application number: 88114476.0

(22) Date of filing: 05.09.88

(54) Method of plasma etching metals that form usually low volatility chlorides.

(30) Priority: 14.09.87 US 96578

(43) Date of publication of application:
05.04.89 Bulletin 89/14

(45) Publication of the grant of the patent:
04.12.91 Bulletin 91/49

(84) Designated Contracting States:
**DE FR GB**

(56) References cited:
**US-A- 4 468 284**

**JOURNAL OF VACUUM SCIENCE & TECH-NOLOGY A, vol. 4, no. 2, second series, March/April 1986, pages 168-172, New York, US; S. PARK et al.: "Halide formation and etching of Cu thin films with Cl2 and Br2"**

**JOURNAL OF VACUUM SCIENCE & TECHNOLOGY/B, vol. 3, no. 1, second series, January/February 1985, pages 9-15, American Vacuum Society, Woodbury, NY, US; H.F. WINTERS: "Etch products from the reaction on Cl2 with Al(100) and Cu(100) and XeF2 with W(111) and Nb"**

(73) Proprietor: **International Business Machines Corporation**
**Old Orchard Road**
**Armonk, N.Y. 10504(US)**

(72) Inventor: **Bausmith, Robert Crowell**
**76 Somerset Road**
**Glastonbury Conn. 06 033(US)**
Inventor: **Cote, William Joseph**
**20 Logwood Circle**
**Essex Junction Vermont 05 452(US)**
Inventor: **Cronin, John Edward**
**RFD No. 3, Arrowhead Estate**
**Milton Vermont 05 468(US)**
Inventor: **Holland, Karey Lynn**
**26 Sleepy Hollow Road**
**Essex Vermont 05 451(US)**
Inventor: **Kaanta, Carter Welling**
**Grandview Road**
**Colchester Vermont 05 446(US)**
Inventor: **Lee, Pei-Ing Paul**
**32 Stirrup Circle**
**Williston Vermont 05 495(US)**
Inventor: **Wright, Terrance Monte**
**3 Lefebvre Lane**
**Williston Vermont 05 495(US)**

(74) Representative: **Mönig, Anton, Dipl.-Ing.**
**IBM Deutschland GmbH Patentwesen und**
**Urheberrecht Schönaicher Strasse 220**
**W-7030 Böblingen(DE)**

## Description

The invention relates to etching metals that form usually low volatility chlorides, and alloys of such metals in a halogen-based gaseous plasma.

For many years, aluminum has been the metallurgy of choice for most integrated circuit applications. Aluminum provides low resistivity characteristics that minimize signal propagation delays and hence enhance chip performance. In order to reduce electromigration defects while enhancing conductivity, small percentages of copper (e.g. up to 10%) have been introduced to form aluminum alloys.

The continuing exponential growth in device density has encouraged process designers to consider metallurgies having enhanced conductivity characteristics. Currently, chemical vapor deposited (CVD) tungsten is being featured in many state-of-the-art designs. However, there is a trend toward finding metallurgies that provide even better conductivity than tungsten. One such metallurgy is pure copper.

In both of the above applications, copper presents difficulties when it is to be etched in an anisotropic mode. Conventionally, metallurgies are anisotropically etched in a reactive ion etch (RIE) mode (i.e., the gaseous plasma is held at a low pressure, and the respective electrodes are held at a high DC bias). Copper reaction products have a low volatility in the presence of the common halogen-based reactive specie that are utilized to etch aluminum metallurgies. In general, this problem has been met by decreasing the chamber pressure and increasing the DC bias, such that the removal mechanism is more of a function of physical bombardment than it is a function of reactive ion complexing. However, with increasing device densities (and the attendant reduced groundrules), the technology has become less tolerant of energetic physical processes.

U.S. Patent 4,468,284 (issued 8/28/84 to Nelson and assigned to Psi Star, Inc.) discloses a process for etching the copper component of an Al/Cu metallurgy. An oxidizing component such as $NO^+$ is added to a conventional Cl-based aluminum RIE. The NO+ causes electron removal from the copper, to produce an intermediate reaction product NOCl. This intermediate product complexes with the $AlCl_3$ products of the Al RIE, to produce a reaction product $CuCl_2$-$Al_2Cl_6$ having a low vapor pressure.

Japanese Unexamined Published Patent Application 55-098827 discloses another method of etching the copper component of an Al/Cu alloy. A thin, high-purity aluminum layer is disposed beneath the Al/Cu alloy. Residual copper is removed during the course of etching the underlying thin Al layer.

Because both of the above prior art processes rely on an in situ aluminum source to provide the complexing agent, they will not provide good results when used to etch either an Al/Cu alloy having a high (>4%) Cu component (hereinafter referred to as "Cu-rich Al/Cu alloys"), Cu-based alloys, or a pure Cu film. In the case of Cu-rich Al/Cu alloy, there will be an excessive amount of Cu present toward the end of the etch cycle relative to the remaining Al. There will not be enough Al available for complexing with the remaining Cu. In the case of the Japanese reference, as the Cu component increases the amount of the underlaying thin Al layer exposed to etching decreases. The above-described drawbacks are particularly true in the case of adaptation to etching a Cu-based alloy or a pure Cu film.

Due to the above-mentioned trends in the technology, a need has developed for a dry etching method that can be used to etch Cu-rich Al/Cu alloys, Cu-based alloys, or pure Cu films, as well as other metal films that normally form low volatility reaction products in Cl-based plasmas.

It is thus an object of the invention to provide a dry etch method that can be used to etch metals that normally form low volatility reaction products in Cl-based plasmas.

It is another object of the invention to provide a single dry etch method that can be used to pattern Cu-rich Al/Cu alloys, Cu-based alloys, and pure Cu films.

The foregoing and other objects of the invention are realized by methods as disclosed in claims 1, 6, 8 and 9.

Using the inventive methods an independent source of Z-Cl reaction products is introduced into a conventional Cl-based plasma. The particular Z-Cl products generated are both chlorine donors and electron acceptors (e.g., $AlCl_3$, $GaCl_3$, etc.). Thus, metals M (e.g., cobalt, copper, or nickel) that usually produce low volatility chlorides can be controllably complexed to form volatile $Z_xCl_yM_z$ reaction products without changing the metallurgy.

Advantageous embodiments of the inventive methods are disclosed in the subclaims.

The invention will become more apparent from the following detailed description.

The invention is based upon the following experimental observations. The above-discussed prior art copper etch techniques relied upon Al-Cl generation during an Al/Cu etch. Ordinarily, one would expect that adding Al-Cl reaction products to the Al/Cu etch plasma would not alter the etch rate of the Al/Cu layer. However, we found that the Al/Cu reaction rate actually increases with the addition of an external source of Al-Cl reaction products. A possible explanation for this rests in the $CuCl_2$-

$AlCl_3$, $CuCl_2$-$Al_2Cl_6$, etc. complexing reactions. Because the complexing reactions occur at the etch front (i.e., the surface being etched), the general Al etch rate may be retarded because surface-generated $AlCl_3$ products are involved in this additional complexing reaction. The higher the Cu percentage, the greater the amount of complexing and the lower the Al/Cu etch rate. Experiments showed that at Cu percentages above approximately 4%, the Al/Cu etch rate is less than one-half the etch rate of pure Al. If Al-Cl products are provided from a source external to the etch front, more surface-generated $AlCl_3$ products may be freed from the complexing reaction and thus can be removed more quickly from the etch front. Thus, the invention is of particular importance in etching Cu-rich Al/Cu alloys.

Experiments were carried out on pure copper films. A one micron thick layer of copper was evaporated onto a silicon substrate having a surface oxide layer. The wafer was exposed for three minutes to a $BCl_3$ (10 SCCM) / $Cl_2$ (20 SCCM) / $CHCl_3$ (12 SCCM) / $N_2$ (100 SCCM) RIE at 366,6 $\mu$bar and 250 Watts. It was found that the copper layer was not appreciably etched. Then an 889 $\mu$m thick aluminum wire was suspended within the etch chamber by forming a coil about the cathode, and the above process was repeated. Note that the aluminum wire was not independently biased (that is, it was at the same bias as the plasma). The copper layer was completely removed.

In several other experiments, the above Al wires were used under conditions identical to those outlined above, and Al/3% Cu/2% Si layers were etched. While the usual etch rate of these films is 300 nm/minute, with the addition of the Al wire the etch rate went up to 450 nm/minute. However, over the course of time, this etch rate enhancement was no longer observed. It was found that over time, etch residuals coated the unbiased Al wire such that it was no longer producing $AlCl_3$ reaction products. This observation lead to the idea of using a biased Al electrode to prevent excessive buildup and to provide Al-Cl reaction products only when needed.

As a function of the above experimental observations, we concluded that the use of an independently-controlled source of Al to produce Al-Cl reaction products greatly enhances formation of $CuCl_2$-$AlCl_3$ and $CuCl_2$-$Al_2Cl_6$ complexes. This allows copper to be etched in a chemical mode as opposed to a physical mode, without changing the metallurgical structure to be etched. Moreover, because the method of the invention provides Al-Cl reaction products from a source external to the etched surface, the invention provides enhanced Al/Cu alloy etch rates. The invention also provides a single method by which Al/Cu alloys, Cu-based alloys, and pure Cu layers may be chemically etched. This versatility is not presented by any prior art plasma etch methods.

Another advantage presented by no longer relying on the workpiece to generate the Al-Cl reaction products is that different metal-chlorine species Z-Cl providing the same Lewis acid (i.e., electron acceptor) and Cl donor properties of $AlCl_3$ can be used to promote the $Z_xCl_yM_z$ complexing reaction. As shown in Table 13 of an article by H. Schaefer, "Gaseous Chloride Complexes With Halogen bridges," Angewandte Chemie - International Edition In English, Vol. 15, No. 12, December 1976, pp. 713-727, materials such as $GaCl_3$, $InCl_3$, or $FeCl_3$ can be used to form gaseous complexes with a host of metals that ordinarily form low volatility chlorides. Of these, the invention is most applicable to the metals in the late transition series (i.e., on the Periodic Table of the Elements, the metals in Groups 7b, 8b, 9b, 10b, 1b, and 2b), and more particularly, cobalt, copper and nickel.

In the invention, it is preferred to utilize a powered Al electrode to controllably introduce Al-Cl reaction products independent of the workpiece. The electrode can be in the form of a ring wound about the outside surface of the ceramic chuck that supports the wafer on the cathode of a plasma etch tool. The cathode is biased to a potential of $-V_t$ - (say minus 200-300 volts DC). The aluminum electrode is coupled to an independent DC source. When a Cl-based reactive ion etch is carried out, ions will be either attracted to or repelled from the aluminum electrode as a function of its potential relative to the cathode as well as to the plasma "dark space" immediately above the wafer in which ions from the plasma are accelerated toward the wafer surface. The voltage of the ions in the dark space is typically slightly above ground potential. If the aluminum electrode is held at a potential slightly above the dark space potential, ions will be repelled from it. If the aluminum electrode is held at a potential that is the same or lower than the plasma potential, ions will be attracted to it. In this latter state, the chlorine-based ions will react with the aluminum to produce an Al-Cl reaction product (e.g., $AlCl_3$, $Al_2Cl_6$, etc.). When the electrode is held at the high potential, the normal etch by-products (i.e., reaction products that are not removed from the chamber) passivate the electrode. When the electrode is switched from high to low potential, the physical component of the RIE causes removal of this passivation layer. The passivation layer provides a further degree of control, in that it protects the electrode from etching when extra Al-Cl reaction products are is not required.

While the invention has been specifically described with reference to a powered Al electrode, other methods of producing $AlCl_3$ independent of

the workpiece can be utilized. One method is to provide an Al wire that can be replenished without exposing the reaction chamber to the atmosphere. This could be accomplished by providing a spool of Al wire supported within a housing attached to the reaction chamber. The wire could be unwound from the spool so that is is exposed outside the housing when desired. Another method is to provide a second reaction chamber coupled to the first reaction chamber. An Al layer could be etched in a Cl-based plasma in the second chamber, and the reactive products from the second chamber could be controllably introduced into the first chamber by a sliding closure, etc. By providing the Al-Cl products from a separate chamber, the Al/Cl ratio can be independently controlled.

While the present invention has been described with reference to a particular Cl-based etch chemistry, any Cl-based etch chemistry will work. The reactions that form the basis of the invention are all Cl-dominated, and as such will be reproducible for different Cl-based chemistries.

## Claims

1. A method of etching a workpiece made up of, or having as a component, a first metal M selected from the group consisting of the late transition series comprising the step of exposing the workpiece in a first reaction chamber to a chlorine-based plasma in the presence of a source of a second metal Z placed apart from the workpiece to provide Z-Cl gaseous products, where the chlorides of Z have both electron acceptor and chlorine donor properties and where said Z-Cl gaseous products serve as the principal complexing agent with said first metal M to form volatile $Z_xCl_yM_z$ reaction products.

2. Method as recited in claim 1, wherein said metal M is selected from the group consisting of cobalt, copper and nickel.

3. Method as recited in claim 1 or 2, wherein said second metal Z is selected from the group consisting of Al, Ga, Fe, and In.

4. Method as recited in any one of claims 1 to 3, wherein said Z-Cl gaseous products are produced by exposing a wire comprised of said second metal Z or an alloy of said second metal Z to said chlorine-based plasma in said first reaction chamber with the wire being preferably independently biased.

5. Method as recited in any one of claims 1 to 4, wherein said Z-Cl gaseous products are produced by etching a workpiece comprised of said second metal Z or an alloy of said second metal Z in a Cl-based plasma generated in a second reaction chamber, and feeding said Z-Cl reaction products from said second reaction chamber to said first reaction chamber.

6. A method of etching a layer made up of, or having as an appreciable component, a metal M of the late transition series, said layer being disposed on a workpiece positioned within a first reaction chamber, comprising the step of exposing the layer to Cl-based gaseous plasma in the presence of a controllable source of Al-Cl reaction products independent of the workpiece which complex with said M to form gaseous $Al_xCl_yM_z$ reaction products.

7. Method as recited in claim 6, wherein said controllable source of Al-Cl reaction products comprises an aluminum wire with said wire being preferably independently biased and being preferably replenished without exposing said first reaction chamber to the atmosphere or comprises a second reaction chamber controllably coupled to said first reaction chamber, an Al-based material being etched in said second chamber in a Cl-based plasma.

8. A method of etching a layer made up of a metal M selected from the group cobalt, copper, or nickel, or of an alloy having an appreciable percentage of cobalt, copper, or nickel, said layer being disposed on a workpiece positioned within a reaction chamber, comprising the step of exposing the layer to a reactive ion etch in a chlorine-based plasma in the presence of an additional aluminum source independent of the workpiece to selectively provide Al-Cl reaction products which complex with said cobalt, copper, or nickel to form high volatility reaction products.

9. In a method of etching Cu films, Cu-based alloys, or Cu-rich Al/Cu alloys in a Cl-based reactive ion etch carried out in a reaction chamber, the improvement comprising the addition of an independently biased aluminum electrode to the reactive chamber to selectively provide additional Al-Cl reaction products when needed to form low volatility complexes with Cu.

10. Method as recited in claim 9, wherein said films or alloys are on a workpiece disposed on a ceramic support within the reaction chamber, and wherein said aluminum electrode comprises a wire wound about said ceramic sup-

**Revendications**

1. Procédé pour attaquer une pièce d'ouvrage faite d'un premier métal M choisi dans le groupe comprenant la dernière série de transition ou ayant un tel métal en tant que composant, comprenant l'étape d'exposition de la pièce d'ouvrage dans une première chambre de réaction à un plasma à base de chlore en présence d'une source d'un second métal Z placée à l'écart de la pièce d'ouvrage pour fournir des produits gazeux Z-Cl, les chlorures de Z ayant à la fois des propriétés d'accepteur d'électron et de donneur de chlore et ces produits Z-Cl gazeux servant d'agent complexant principal avec ce premier métal M pour former des produits réactionnels volatils $Z_xCl_yM_z$.

2. Procédé suivant la revendication 1, dans lequel ce métal M est choisi dans le groupe consistant en cobalt, cuivre et nickel.

3. Procédé suivant la revendication 1 ou la revendication 2, dans lequel ce second métal Z est choisi dans le groupe consistant en Al, Ga, Fe et In.

4. Procédé suivant l'une quelconque des revendications 1 à 3, dans lequel ces produits gazeux Z-Cl sont produits par exposition d'un fil composé de ce second métal Z ou d'un alliage de ce second métal Z à ce plasma à base de chlore dans cette première chambre de réaction, le fil étant de préférence polarisé de façon indépendante.

5. Procédé suivant l'une quelconque des revendications 1 à 4, dans lequel ces produits gazeux Z-Cl sont produits par attaque d'une pièce d'ouvrage composée de ce second métal Z ou d'un alliage de ce second métal Z dans un plasma à base de chlore généré dans une seconde chambre de réaction, et introduction de ces produits réactionnels Z-Cl depuis cette seconde chambre de réaction dans cette première chambre de réaction.

6. Procédé pour attaquer une couche faite d'un métal M de la dernière série de transition ou ayant un tel métal en tant que composant appréciable, cette couche étant disposée sur une pièce d'ouvrage positionnée a l'intérieur d'une première chambre de réaction, comprenant l'etape d'exposition de la couche à un plasma gazeux à base de chlore en présence d'une source contrôlable de produits réactionnels Al-Cl indépendante de la pièce d'ouvrage, lesquels se complexent avec ce M pour former des produits réactionnels $Al_xCl_yM_z$ gazeux.

7. Procédé suivant la revendication 6, dans lequel cette source contrôlable de produits réactionnels Al-Cl comprend un fil d'aluminium, ce fil étant de préférence polarisé de façon indépendante et étant de préférence renouvelé sans exposition de cette première chambre de réaction à l'atmosphère ou comprend une seconde chambre de réaction couplée de façon contrôlable à cette première chambre de réaction, un matériau à base d'aluminium étant attaqué dans cette seconde chambre dans un plasma à base de chlore.

8. Procédé pour attaquer une couche faite d'un métal M choisi dans le groupe comprenant le cobalt, le cuivre ou le nickel, ou d'un alliage ayant un pourcentage appréciable de cobalt, cuivre ou nickel, cette couche étant disposée sur une pièce d'ouvrage positionnée à l'intérieur d'une chambre de réaction, comprenant l'étape d'exposition de la couche à une attaque par ions réactifs dans un plasma à base de chlore en présence d'une source d'aluminium supplémentaire indépendante de la pièce d'ouvrage pour fournir sélectivement des produits réactionnels Al-Cl qui se complexent avec ce cobalt, cuivre ou nickel pour former des produits réactionneis de haute volatilité.

9. Dans un procédé pour attaquer des films de Cu, des alliages à base de cuivre, ou des alliages d'Al/Cu riches en cuivre par attaque par ions réactifs à base de chlore dans une chambre de réaction, l'amélioration comprenant l'addition d'une électrode d'aluminium polarisée de façon indépendante à la chambre de réaction pour fournir sélectivement des produits réactionnels de type Al-Cl supplémentaires lorsqu'il est nécessaire de former des complexes de faible volatilité avec le cuivre.

10. Procédé suivant la revendication 9, dans lequel ces films ou alliages sont sur une pièce d'ouvrage disposée sur un support de céramique à l'intérieur de la chambre de réaction, cette électrode d'aluminium comprenant un fil enroulé autour de ce support de céramique.

**Patentansprüche**

1. Verfahren zum Ätzen eines Werkstückes, das aus einem ersten Metall besteht oder es als Bestandteil enthält, das aus der Gruppe ausgewählt wurde, die aus der hinteren Reihe der später entdeckten Übergangsmetalle besteht, welches Verfahren den Schritt umfaßt, das Werkstück in einer ersten Reaktionskammer einem Plasma auf Chlorbasis in Gegenwart einer Quelle eines zweiten Metalles Z auszusetzen, das getrennt von dem Werkstück angeordnet ist, um Z-Cl gasförmige Produkte bereitzustellen, wobei die Chloride von Z sowohl Elektronenakzeptor- als auch Chlordonatoreigenschaften aufweisen und wobei die gasförmigen Z-Cl-Produkte als Hauptkomplexbildner für das erste Metall M dienen, um flüchtige $Z_xCl_yM_z$-Reaktionsprodukte zu bilden.

2. Verfahren nach Anspruch 1, bei dem das Metall M aus der Gruppe ausgewählt wurde, die aus Kobalt, Kupfer und Nickel besteht.

3. Verfahren nach Anspruch 1 oder 2, bei dem das zweite Metall Z aus der Gruppe ausgewählt wurde, die aus Al, Ga, Fe und In besteht.

4. Verfahren nach einem der Ansprüche 1 bis 3, bei dem die gasförmigen Z-Cl-Produkte erzeugt werden durch Aussetzen eines Drahtes aus dem zweiten Metall Z oder aus einer Legierung des zweiten Metalls Z einem auf Chlorgas basierenden Plasma in der ersten Reaktionskammer, wobei der Draht vorzugsweise unabhängig vorgespannt ist.

5. Verfahren nach einem der Ansprüche 1 bis 4, bei dem die gasförmigen Z-Cl-Produkte erzeugt werden durch Ätzen eines Werkstückes, das aus dem zweiten Metall Z oder einer Legierung des zweiten Metalls Z besteht, in einem auf Cl-basierenden Plasma, das in einer zweiten Reaktionskammer erzeugt wird, und durch Zuführen der Z-Cl-Reaktionsprodukte aus der zweiten Reaktionskammer in die erste.

6. Verfahren zum Ätzen einer Schicht, die aus einem Metall M der hinteren Reihe der Übergangsmetalle besteht oder es als merklichen Bestandteil enthält, wobei die Schicht auf einem Werkstück angeordnet ist, das sich in einer ersten Reaktionskammer befindet, und das Verfahren die Schritte enthält des Aussetzens der Schicht einem gasförmigen auf Cl-basierenden gasförmigen Plasma in Gegenwart einer steuerbaren Quelle von Al-Cl-Reaktionsprodukten unabhängig von dem Werkstück, die mit M einen Komplex bilden, um gasförmige $Al_xCl_yM_z$-Reaktionsprodukte zu bilden.

7. Verfahren nach Anspruch 6, bei dem die steuerbare Quelle für Al-Cl Reaktionsprodukte einen Aluminiumdraht umfaßt, der vorzugsweise unabhängig vorgespannt ist und der vorzugsweise nachgefüllt wird, ohne die erste Reaktionskammer der Atmosphäre auszusetzen, oder das eine zweite Reaktionskammer umfaßt, die steuerbar mit der ersten Reaktionskammer gekoppelt ist, wobei ein auf Al basierendes Material in der zweiten Reaktionskammer in einem auf Cl basierenden Plasma geätzt wird.

8. Verfahren zum Ätzen einer aus einem Metall M bestehenden Schicht, das aus der Gruppe Kobalt, Kupfer oder Nickel ausgewählt wurde oder das aus einer Legierung besteht, die einen merklichen Prozentsatz von Kobalt, Kupfer oder Nickel enthält, wobei die Schicht auf einem Werkstück angeordnet ist, das sich in einer Reaktionskammer befindet, die Schritte umfassend des Aussetzens der Schicht einem reaktionsfreudigen Ionenätzen in einem auf Chlor basierenden Plasma in der Gegenwart einer zusätzlichen Aluminiumquelle, die unabhängig von dem Werkstück ist, um selektiv Al-Cl-Reaktionsprodukte bereitzustellen, die mit dem Kobalt, Kupfer oder Nickel einen Komplex bilden, um hochflüchtige Reaktionsprodukte zu bilden.

9. In einem Verfahren des Ätzens von Cu-Filmen, von auf Cu basierenden Legierungen oder von Cu-reichen Al/Cu Legierungen in einem auf Cl basierenden reaktionsfreudigen Ionenätzen, das in einer Reaktionskammer ausgeführt wird, die Verbesserung, die in dem Hinzufügen einer unabhängig vorgespannten Aluminiumelektrode zu der Reaktionskammer besteht, um selektiv zusätzliche Al-Cl-Reaktionsprodukte bereitzustellen, wenn das erforderlich ist, um niederflüchtige Komplexe mit Cu zu bilden.

10. Verfahren nach Anspruch 9, bei dem die Filme oder Legierungen sich auf einem Werkstück befinden, das auf einem keramischen Träger in einer Reaktionskammer angeordnet ist und bei dem die Aluminiumelektrode einen Draht umfaßt, der um den keramischen Träger gewickelt ist.